Europäisches Patentamt

European Patent Office

Office européen des brevets

(19)

(11)     EP 0 617 309 B1

(12)              **EUROPEAN PATENT SPECIFICATION**

(45) Date of publication and mention
of the grant of the patent:
**29.03.2000  Bulletin 2000/13**

(51) Int. Cl.[7]: **G02F 1/133**, G09G 3/36

(21) Application number: **94106662.3**

(22) Date of filing: **16.05.1989**

(54) **Active matrix panel**

Tafel mit aktiver Matrix

Panneau à matrice active

(84) Designated Contracting States:
**DE FR GB NL**

(30) Priority: **17.05.1988 JP 11991988**

(43) Date of publication of application:
**28.09.1994  Bulletin 1994/39**

(62) Document number(s) of the earlier application(s) in
accordance with Art. 76 EPC:
**89304929.6 / 0 342 925**

(73) Proprietor:
**SEIKO EPSON CORPORATION
Tokyo 160-0811 (JP)**

(72) Inventors:
• **Misawa, Toshiyuki
Suwa-shi, Nagano-ken (JP)**

• **Oshima, Hiroyuki
Suwa-shi, Nagano-ken (JP)**

(74) Representative:
**Sturt, Clifford Mark et al
Miller Sturt Kenyon
9 John Street
London WC1N 2ES (GB)**

(56) References cited:
**FR-A- 2 594 580          GB-A- 2 070 857
JP-A- 63 052 121**

• **PROCEEDINGS OF THE SID, vol.27, no.3, 1986,
LOS ANGELES, US pages 235 - 238 T. SUNATA
ET AL.: 'A 640 * 400 Pixel Active-Matrix LCD
Using a-Si TFT's'**

**Description**

The invention relates to an active matrix panel.

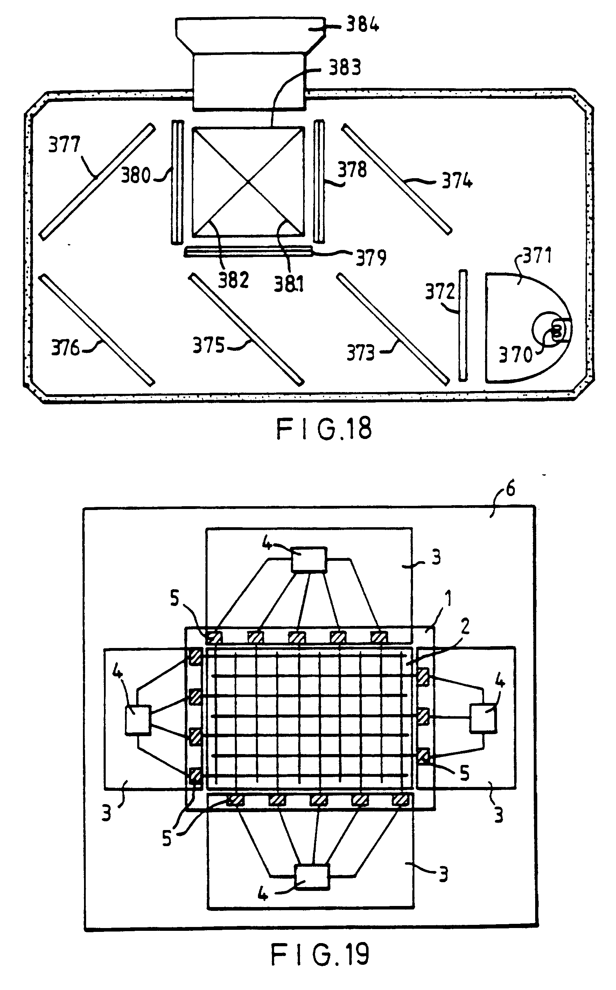

A conventional active matrix liquid crystal panel as disclosed in "SID-83 digest pp. 156 - 157, B/W and colour LC video displays addressed by polysilicon TFTs" (Morozumi et al) is illustrated in Figure 19. Such an active matrix panel 1 comprises a picture element matrix 2, which utilises thin film transistors and which is formed on a transparent substrate. Gate line drive circuits and source line drive circuits 4, in the form of MOS integrated circuits composed of mono-crystal silicon, are attached to the edges of the active matrix panel 1 as shown, each drive circuit 4 being mounted on a respective flexible substrate 3 and being connected to the picture element matrix 2 of the active matrix panel 1 at pads 5. A mounting substrate 6 provides both mechanical support for the flexible substrates 3 and the active matrix panel 1 and electrical connection between the drive circuits 4 and external circuitry (not shown).

This conventional arrangement has the following disadvantages:

(1) High resolution is prevented.

In the prior art, each source or gate line of the active matrix panel 1 is connected to the associated drive circuit 4 at a respective pad 5 so that close positioning of the picture elements is limited by the pad interval required for forming the connections during mounting. Therefore, mass production of the active matrix panel with a picture element spacing of 100 microns or less is very difficult and so high resolution cannot be obtained.

(2) Miniaturisation of the display device is prevented.

In the conventional arrangement shown in Figure 19, each drive circuit 4 is mounted outside the active matrix panel 1 so that the external dimensions of the mounting substrate 6 have to be a fourth or fifth as large again as the dimensions of the picture element matrix 2. Therefore, the dimensions of the display device employing the active matrix panel 1 must inevitably be larger than the dimensions of the picture element matrix 2, which is the portion contributing to the display, and this limits the application of the active matrix panel in a micro-monitor, such as a view finder for a video camera.

(3) The production cost is expensive.

The production of a display device employing the arrangement shown in Figure 19 involves the process of connecting the flexible substrates 3 with the active matrix panel 1, the process of connecting the drive circuits 4 with the flexible substrates 3, and the process of mounting the flexible substrates 3 and the active matrix panel 1 on the mounting substrate 6, which renders production expensive.

(4) The reliability is low.

Due to the many connections, for example between the active matrix panel 1 and the flexible substrates 3 and between the drive circuits 4 and the flexible substrates 3, and the stresses applied to the connecting portions in use, the connecting strength has been found to be insufficient. Thus, the reliability of the whole display device is inherently low, whereas the expense of ensuring reliability is great.

It is an object of the invention to overcome the above problems and to provide an improved active matrix panel, which is inexpensive and has a small size and which is capable of both high resolution and high reliability.

According to the present invention, there are provided active matrix panels, drive circuits therefor and projection type colour display devices according to the claims.

Preferably the gate line drive circuit comprises a shift register and a buffer arranged in that order with the buffer closer to the picture element matrix. Conveniently, the source line drive circuit includes a sample and hold circuit.

The gate length of a thin film transistor in the sample and hold circuit may be less than the gate length of a thin film transistor in the shift register.

Typically, the source line drive circuit has a pair of clock lines, which cross one another. The panel may include testing means for testing each output from the gate line drive circuit ad the source line drive circuit.

Such a active matrix panel can advantageously be employed in an electric view finder for a video camera, a monitor for a portable VTR and the like.

The invention will be described further, by way of example, with reference to the accompanying drawings, in which:

Figure 1 is a circuit diagram of an active matrix panel embodying the present invention;

Figures 2 (a) to 2 (f) show examples of the detailed structure of a drive circuit shown in Figure 1;

Figures 3 (a) and 3 (b) are cross sections through parts of the active matrix panel shown in Figure 1;

Figures 4 (a) to 4 (d) illustrate stages in the method of manufacturing an active matrix panel according to the present invention;

Figure 5 is a graph showing the characteristic of a thin film transistor employed in the invention in comparison with that of a mono-crystalline silicon MOSFET;

Figure 6 is a diagram for illustrating the terms "gate length" and "gate width";

Figure 7 is a cross sectional view through a thin film transistor employed in the invention showing depletion layer width and film thickness in a layer of silicon thin film;

Figures 8, 9, 10 (a) and 10 (b) illustrate a first modification of the active matrix panel;

Figures 11 (a) and 11 (b) illustrate a second modification of the active matrix panel;

Figure 12 illustrate a third modification of the active matrix panel;

Figures 13 (a) and 13 (b) illustrate a fourth modification of the active matrix panel;

Figure 14 illustrates a fifth modification of the active matrix panel;

Figures 15 (a) and 15 (b) illustrate a sixth modification of the active matrix panel;

Figures 16 (a) and 16 (b) illustrate a seventh modification of the active matrix panel;

Figure 17 is a diagram illustrating a first application of the active matrix panel;

Figure 18 is a diagram illustrating a second application of the active matrix panel; and

Figure 19 is a circuit diagram of an active matrix panel according to the prior art.

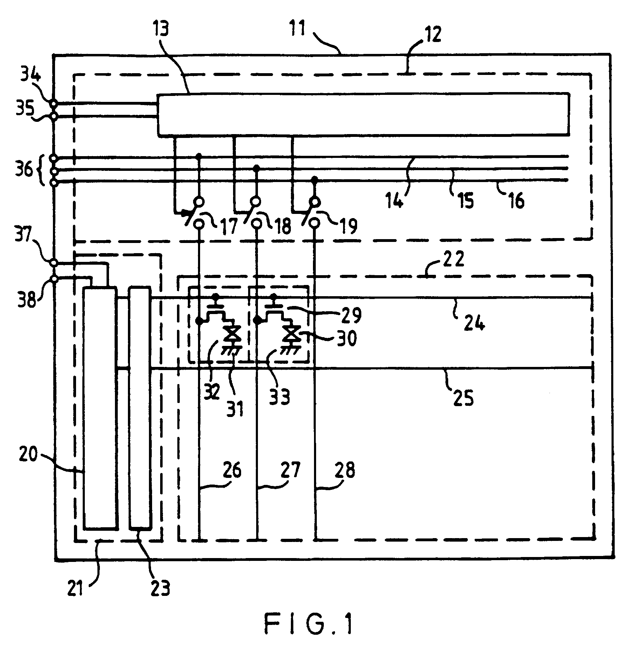

Figure 1 shows an embodiment of the invention, wherein an active matrix panel 11 comprises a source line drive circuit 12, a gate line drive circuit 21, and a picture element matrix 22, all being of complementary metal oxide semi-conductor structure (hereinafter referred to as a CMOS structure) made of silicon thin film and formed on the same transparent substrate. The source line drive circuit 12 includes a shift register 13, a sample and hold circuit comprising thin film transistors 17, 18 and 19 (hereinafter referred to as TFTs) and video signal buses 14, 15 and 16. The gate line drive circuit 21 includes a shift register 20, and it may also include a buffer 23 if occasion demands. The picture element matrix 22 includes a plurality of source lines 26, 27, and 28 connected to the source line drive circuit 12, a plurality of gate lines 24 and 25 connected to the gate line drive circuit 21, and a plurality of picture elements 32 and 33 formed at intersections of the source and gate lines. Each picture element 32, 33 includes a TFT 29, and a liquid crystal cell 30, which comprises a picture element electrode, and opposite electrode 31 and a layer of liquid crystal material between the electrodes. It is possible for other circuits, such as a counter or a de-coder having the function of selecting the source linen and the gate lines in order, to be substituted for one of the shift registers 13 and 20. A clock signal CLX, a start signal DX and video signals V1, V2 and V3 are supplied in use to input terminals 34, 35 and 36 respectively of the source line drive circuit 12. A clock signal CLY and a start signal DY are supplied to input terminals 37 and 38 respectively of the gate line drive circuit 21.

The shift registers 13 and 20 shown in Figure 1 are static circuits composed of complementary TFTs, consisting of P type and N type TFTs, Given the performance of a TFT as a device, a static type of circuit composed of complementary TFTs is the optimum one. Since a TFT for an active matrix panel is generally formed on an insulating substrate with poly-crystalline silicon, a smaller ON current and a larger OFF current are produced than is the case with a metal oxide semi-conductor field effect transistor (hereinafter referred to as a MOSFET). The reason for this is that the trap density existing in a silicon thin film is very high in comparison with that in a mono-crystalline silicon whereby the carrier mobility is low and re-combination of carriers at a P-N junction which is reverse biased occurs frequently. In view of these characteristics of the TFT as a device, a static shift register composed of complementary TFTs is preferred generally and such a shift register is also preferred for the following reasons:

(1) As a TFT has a large OFF current, the operating voltage range, operating frequency range, and operating temperature range of a dynamic circuit consisting of TFTs is very small.
(2) A drive circuit needs to have a CMOS structure with a low consumption of current for making the best use of the advantage of the active matrix liquid crystal panel, which is its low current consumption.
(3) The ON current value can be smaller than that in a mono-conductive MOS dynamic shift register.

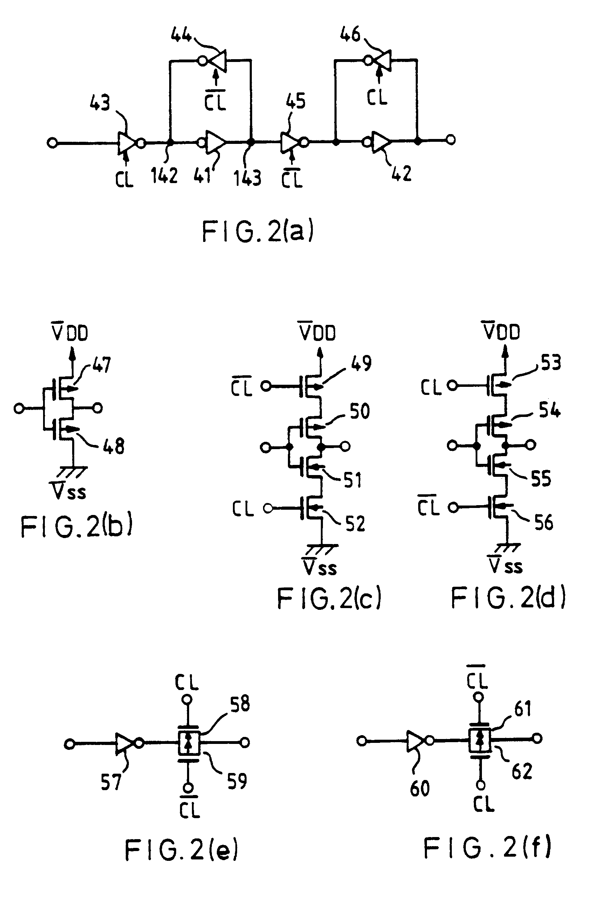

Figure 2 (a) shows a suitable circuit structure for each of the shift registers 13 and 20 in Figure 1. Inverters 41 and 42 in Figure 2 (a) consist of a P type TFT 47 and an N type TFT 48 as shown in Figure 2 (b). Further, clocked inverters 43 and 46 in Figure 2 (a) consist of P type TFTs 49, 50 and of N type TFTs 51, 52, respectively, as shown in Figure 2 (c). A clock signal CL is input to the gate of the N type TFT 52, and an inverted clock signal $\overline{CL}$ is input to the gate of the P type TFT 49. Likewise, clocked inverters 44 and 45 in Figure 2 (a) consist of P type TFTs 53, 54 and N type TFTs 55, 56, respectively, as shown in Figure 2 (d). The inverted clock signal $\overline{CL}$ is input to the gate of the N type TFT 56 and the clock signal CL is input to the gate of the P type TFT 53. An alternative possibility is for a circuit made up of an analog switch consisting of an inverter 57, an N type TFT 58 and a P type TFT 59, as shown in Figure 2 (e), to be substituted for the clocked inverters 43 and 46, and for a circuit made up of an analog switch consisting of an inverter 60, an N type TFT 61 and a P type TFT 62, as shown in Figure 2 (f), to be substituted for the clocked inverters 44 and 45.

As described above, it is very beneficial to construct a drive circuit for an active matrix panel from TFTs having a CMOS structure. However, the mere application of a complementary TFT integrated circuit in the prior art has disadvantages as described below:

(1) A method of production for integrating both a P type TFT and an N type TFT on the same substrate in complicated and renders the overall circuit expensive.
(2) It is difficult to form a P type TFT and an N type TFT having balanced characteristics, which is essential for forming a complementary TFT integrated circuit.
(3) A P type TFT and an N type TFT do not have enough driving ability for realising a drive circuit.

Such disadvantages are solved in the present instance by employing a method of manufacture, and a structure having dimensions and utilising materials as described below.

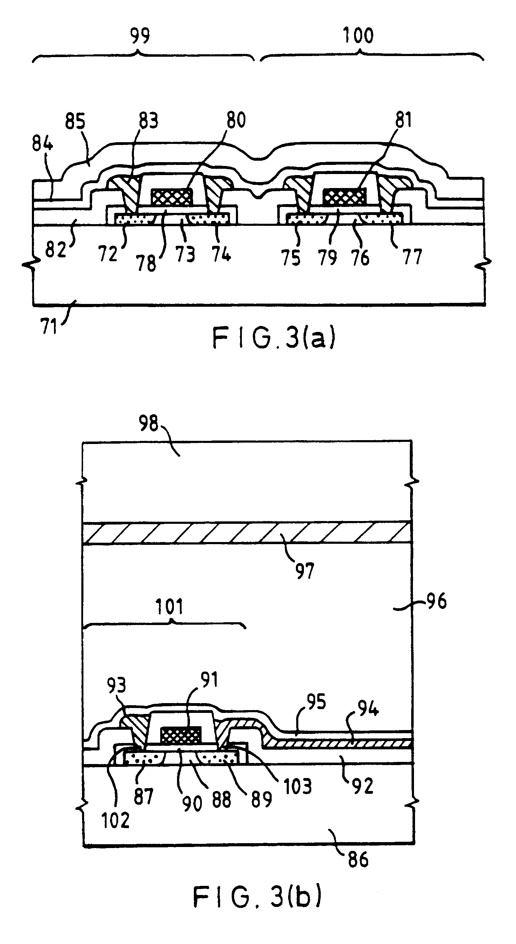

Figure 3 (a) is a section through a pair of complementary TFTs for forming either the source line drive circuit 12 or the gate line drive circuit 21 shown in Figure 1, and Figure 3 (b) is a section through the respective picture element 32 of Figure 1, which includes a liquid crystal cell.

In Figure 3 (a), a P type TFT 99 and an N type TFT 100 are formed on an insulating substrate 71 made of glass, quartz crystal or the like. Silicon thin film regions 73, 76 are channel regions of the TFTs 99, 100 and silicon thin film regions 72, 74, 75, 77 are source and drain regions. The silicon thin film regions 72 and 74 are impurity doped to be P type, and the silicon thin film regions 75 and 77 are impurity doped to be N type. Gate insulating film regions 78 and 79 are made of silicon oxide (for example $SiO_2$), silicon nitride or the like, and gate electrodes 80 and 81 are made of poly-crystalline silicon. The TFTs further comprise an insulating film layer 82 made of silicon oxide (for example $SiO_2$), silicon nitride or the like, a line layer 83 made of metal or the like, an insulating film layer 84 made of silicon oxide (for example $SiO_2$), silicon nitride or the like, and a passivation film layer 85.

In Figure 3 (b), the reference numeral 86 indicates the same insulating substrate 71 as in Figure 3 (a), a picture element electrode 94 consisting of transparent conductive film made of ITO (indium tin oxide) or the like, and a picture element TFT 101 being formed thereon. The reference numerals 87, 88 and 89 indicate silicon thin film regions which are formed from the same layers as the regions 72, 73, 74 and 75, 76, 77, the silicon thin film region 88 forming a channel region and the silicon thin film regions 87 and 89 forming source and drain regions, respectively, of the TFT 101. The regions 87 and 89 are impurity doped to be P type or N type, the impurities in such regions being the same as those included in the regions 72 and 74 or the regions 75 and 77. The reference numeral 90 indicates a gate insulating film region, which is formed from the same layer as the gate insulating film regions 78 and 79, and the reference numeral 91 indicates a gate electrode, which is formed from the same layer as the gate electrodes 80 and 81. The reference numeral 92 indicates an insulating film region which is formed from the same layer as the insulating film region 82, the reference numeral 93 indicates a line layer, which is formed from the same layer as the line layer 83, and the reference numeral 95 indicates an insulating film layer, which is formed from the same layer as the insulating film layer 84. A layer 96 of liquid crystal is provided between the insulating film layer 95 and a counter electrode 97, which includes a transparent conductive film layer and which is provided on a transparent substrate 98.

Accordingly, the source/drain region, the channel region, the gate insulating film region and the gate electrode of each of the TFTs 99 and 100 forming the drive circuit are provided by the same thin film layers as the corresponding regions of the picture element TFT 101. Further, the TFTs in the source line drive circuit and the gate line drive circuit are connected through the line layer 83, which is designed to have a low sheet resistance (being formed, for example, from a metal such as aluminium), and the line layer 93 consisting of the same layer as the line layer 83 provides a source line in the picture element matrix. A picture element electrode 94 is made of a transparent conductive film layer such as ITO. In the case that the line layer 93 is made of aluminium or alumi-silicide and the transparent conductive film layer is made of ITO and no insulating film layer is arranged therebetween, through holes 102 and 103 opened simultaneously can be used for connecting the line layer 93 and the electrode 94 and she silicon thin film regions 87, 89 whereby the manufacturing process can be simplified. In this case, the aluminium and the ITO are processed in respective etching solutions and the ITO is formed for patterning in the stage prior to the aluminium, taking advantage of the fact that the ITO is not soaked in the etching solution for aluminium.

In Figure 3 (b), the insulating film layer 95 provides a capacitor for preventing application of a DC voltage to the liquid crystal layer 96 and the capacitance value thereof should be large enough in comparison with that of the picture element for this purpose. Thus, the thickness of the layer 95 should be a predetermined value (for example, approximately 3000 Angstrom) or less. On the other hand, the TFTs 99, 100 of the drive circuit shown in Figure 3 (a) need to be covered by the passivation film layer 85, which is designed to have a thickness larger than a predetermined value (for example, approximately 1 micron) for ensuring wet-proofing. For forming the passivation film layer 85, it is most effective to form a film all over the active matrix substrate and then to remove the film except in the region of the drive circuits. Hence, the passivation film layer 85 is made from a material such as polyimide or the like processed with an etching solution, in which the insulating film layer 84 is not soaked.

The method of manufacture for such a structure and the characteristics of the complementary TFTs obtained therefrom are described below. In a method of manufacturing a CMOS integrated circuit utilising conventional mono-crystalline silicon, at least four photo processes are needed (a process for forming a low concentration P well, a process for forming a P type stopper layer, a process for forming the source/drain regions of each P type MOSFET, and a process for forming the source/drain regions of each N type MOSFET) in comparison with a method of manufacturing an N type MOSFET integrated circuit. Contrary to this, a complementary TFT integrated circuit according to the invention can be realised by adding no more than one photo process as compared with a method of manufacture for a mono-conductive TFT integrated circuit.

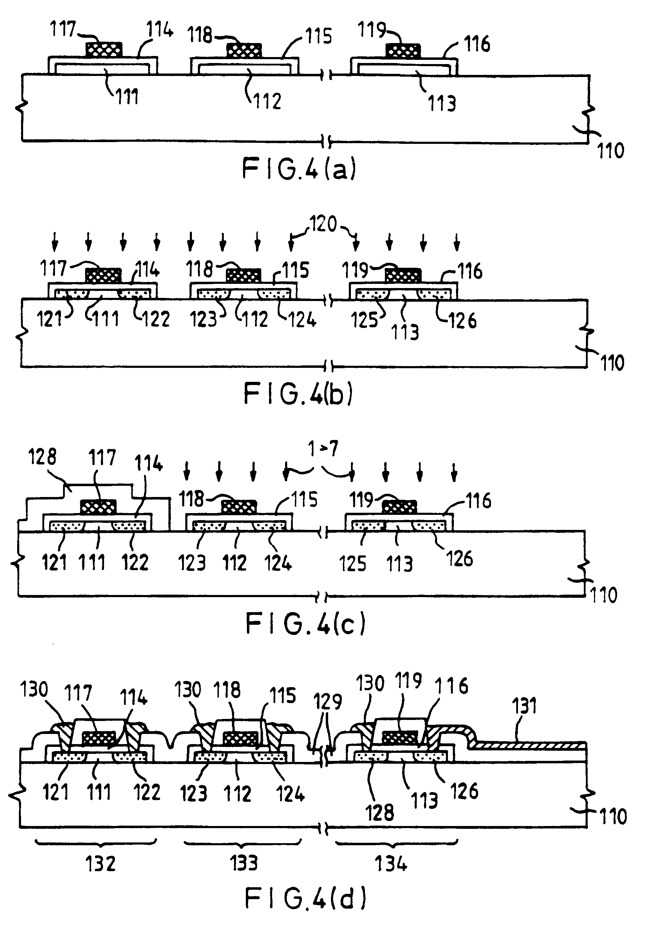

Figures 4 (a) to 4 (d) illustrate an example of the main stages in a method of manufacturing the active matrix panel according to the present invention. First, as shown in Figure 4 (a), a desired pattern is formed after accumulating a layer of silicon thin film over a transparent insulating substrate 110 and thereby forming a channel region 111 of a P type TFT and channel regions 112 and 113 of N type TFTs. Next, gate insulating film regions 114, 115 and 116 are formed by means of thermal oxidation or chemical vapour deposition, and then gate electrodes 117, 118 and 119 are formed.

Next, as shown in Figure 4 (b), acceptor impurities 120, for example boron, are implanted all over the surface utilising ion implantation techniques. Implanted acceptor impurities in regions 121, 122 are activated by subsequent heat treatment to form a P type semi-conductor. Acceptor impurities are also added to regions 123, 124, 125 and 126, which are to be the source/drain regions of N type TFTs.

After this, as shown in Figure 4 (c), the P type TFTs covered by a mask material such as photo resist 128, and donor impurities 127, such as phosphorus or arsenic, are implanted elsewhere with a higher concentration than that of the acceptor impurities 120. Implanted donor impurities in the regions 123 to 126 are activated by subsequent heat treatment. If the implant dosage of the acceptor ions is $1 \times 10^{15}$ cm$^{-2}$ and the implant dosage of the donor ions is $3 \times 10^{15}$ cm$^{-2}$, then the regions 123 to 126 contain the equivalent of an implant dosage of the donor ions having a concentration of $2 \times 10^{-15}$ cm$^{-2}$. In this way, source/drain regions 123 to 126 of the N type TFTs are formed.

Subsequently, as shown in Figure 4 (d), an insulating film layer 129 is accumulated after removing mask material 128, through holes are opened, a picture element electrode 131 made of transparent conductive film is formed and a line 130 made of metal or the like is formed.

As described, a P type TFT 132 and an N type TFT 133 for forming the drive circuit and an N type TFT 134 for forming a picture element TFT of the matrix panel are thus produced. It is a matter of course that a P type TFT for the matrix panel can also be produced. The TFTs thus obtained include a P type TFT having acceptor impurities in its source/drain region, and N type TFTs having both acceptor impurities and donor impurities in their source/drain regions but with the latter having a higher concentration than the former.

In the above process of manufacture, if donor impurities 127 are substituted for acceptor impurities 120 in Figure 4 (b) and acceptor impurities 120 are substituted for the donor impurities 127 in Figure 4 (c), an N type TFT 132 and P type TFTs 133, 134 as shown in Figure 4 (d) are obtained instead. The TFTs thus obtained include an N type TFT having donor impurities in its source/drain region and P type TFTs having both donor impurities and acceptor impurities in their source/drain regions but the latter having a higher concentration that the former.

A complementary TFT integrated circuit can thus be formed by adding the single photo process required to form the mask pattern 128 in Figure 4 (c), as compared with the method of manufacture for a mono-conductive TFT integrated circuit. As a result, an active matrix panel with a built-in drive circuit can be realised. From an economical point of view, the above method of manufacture is an improvement, and it is not inconvenient to form a mask pattern independently for the ion implantation of acceptor impurities and donor impurities. Further, in the complementary TFT integrated circuit manufactured by the above method, each TFT is separated in the form of an island on the insulating substrate 110 so that a specific process for element separation is not required. Further, being different from an integrated circuit made of mono-crystalline silicon, no parasitic MOSFET is produced so that a channel stopper does not have to be formed.

Next, a means for realizing a P type TFT and an N type TFT having balanced characteristics as required for a complementary integrated circuit will be described. TFTs making use of the groups II to VI semi-conductor compounds have been known in the art for a long time. However, a complementary TFT making use of a compound semi-conductor has not been realized for the following two reasons:-

(1) It is actually impossible to control and realize both P type and N type semi-conductors in the semi-conductor compound.
(2) It is very difficult to control the interface between the semi-conductor compound and the insulating film for a MOS construction.

Accordingly, source/drain regions and a channel region are made of silicon thin films. The carrier mobilities of amorphous silicon thin film and of poly-crystalline silicon thin film are shown in Table 1. As shown by the Table, the poly-crystalline thin film is the better for realising a complementary TFT integrated circuit because characteristics of P type and of N type semi-conductors can easily be made well balanced and the current supply capacity of the TFT can be made larger.

TABLE 1

|  | carrier mobility ($cm^2$/V sec) | |
| --- | --- | --- |
|  | N type | P type |
| amorphous silicon | 0.1 - 1 | $10^{-4}$ - $10^{-3}$ |
| poly-crystalline silicon | 5 - 50 | 5 - 50 |

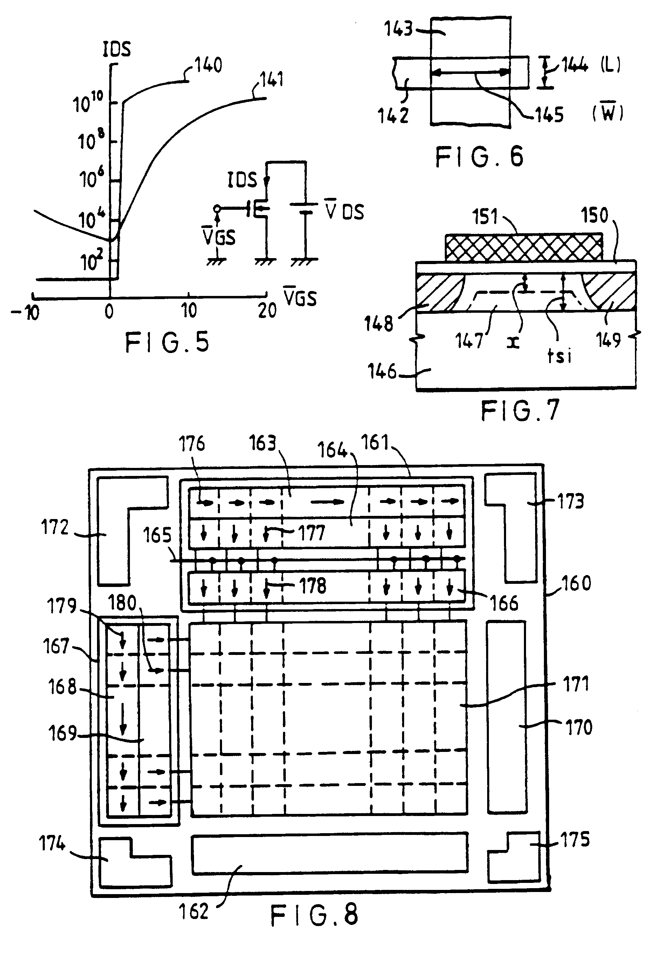

Next will be described a means for increasing the current supply capacity of a TFT, especially P type and N type TFTs for forming a drive circuit as in the present invention. As described above, the trap density is high in a TFT made of silicon thin film which is not mono-crystalline silicon so that the ON current is small and the OFF current is large in comparison with a mono-crystalline silicon MOSFET. Figure 5 is a graph showing a characteristic 140 of a mono-crystalline silicon MOSFET and a characteristic 141 of a TFT made of silicon thin film in the case in which the gate length, gate width and source/drain voltage VDS are the same. The abscissa represents the voltage VGS based on the source as the reference, and the ordinate represents the current IDS between the source and the drain. As shown by the graph, since the ON/OFF ratio of the TFT is small, the TFT 29 for the picture element matrix and the TFTs forming the drive circuit 12 and 21 in Figure 1 respectively should be formed with the optimum dimensions. For instance, when an image is to be displayed making use of an NTSC video signal, the TFT 29 for the picture element matrix should satisfy the following equations within the entire temperature range wherein the active matrix panel is used.

$$0.1 \times C_1 \times R\,OFF1 \geq 1/60\ (sec) \tag{1}$$

$$5 \times C_1 \times R\,ON1 \leq 10\ (\mu\,sec) \tag{2}$$

where $C_1$ represents the total capacity of a picture element, and R ON1 and R OFF1 represent ON resistance and OFF resistance of the TFT, respectively. Equation (1) is a condition to be satisfied by all of the picture elements in the matrix panel during a holding operation (holding condition), and 90% and more of the electric charge which is written into any picture element can be held over for one field if it is satisfied. Equation (2) is a writing condition to be satisfied by all of the picture elements in the matrix panel during a writing operation (writing condition), and 99% and more of a video signal can be written into a picture element if it is satisfied.

On the other hand, a TFT for forming a drive circuit should satisfy the following equation within the entire temperature range wherein the active matrix panel is used.

$$K \times (C2RON2 + C3RON3) \leq 1/2f \tag{3}$$

where C2 and C3 represent the capacities of junctions 142 and 143 in Figure 2 (a), RON2 and RON3 are the output resistances of the clocked inverter 43 and the inverter 41 of Figure 2 (a) respectively, _f_ is the clock frequency of the shift register 13 or 20, and K is a constant (K is approximately from 1.0 to 2.0, by experience). According to the actual survey or simulation performed, RON2 and RON3 of the TFT for forming the drive circuit should be a tenth or less of RON1 of a picture element TFT in order to realize a shift register with approximately 2 MHZ of the clock frequency f.

For realising such low output resistance, the gate length of the TFT for the drive circuit can be formed as short as possible within the limits of the breakdown voltage permitted. Further, TFTs for the sample and hold circuit 17, 18 and 19 shown in Figure 1 permit a lower breakdown voltage than the TFTs for the shift register 13 so that the gate lengths of the former can be shorter than those of the latter. Figure 6 illustrates the definition of gate length L and Table 2 shows an example of the gate lengths for each of the TFTs. In Figure 6, a gate electrode 142 and a silicon thin film 143 making up a channel region together define a gate length 144 and a gate width 145.

TABLE 2

| | Gate length L (μm) | |
| --- | --- | --- |
| | P type TFT | N type TFT |
| TFT for picture element matrix | | 20.0 |
| TFT for shift register | 4.0 | 5.5 |
| TFT for sample and hold circuit | | 4.5 |

It is also possible to raise the current supply capacity of a P type TFT and an N type TFT by constructing the TFT such that the thickness of the silicon thin film forming the channel region is smaller than the maximum width of the depletion layer extending over the surface of the silicon thin film.

The maximum width $X_{PMAX}$ of the depletion layer of a P type TFT made of silicon thin film and the maximum width $X_{NMAX}$ of the depletion layer of an N type TFT are represented by the following equations, respectively.

$$X_{PMAX} = (2\varepsilon \times 2 \phi FP)^{1/2} \times (q \times ND)^{-1/2} \tag{4}$$

$$X_{NMAX} = (2\varepsilon \times 2 \phi FN)^{1/2} \times (q \times NA)^{-1/2} \tag{5}$$

where $q$ represents a unit electric charge, $\varepsilon$ is a dielectric constant of silicon thin film, $\phi FP$ represents a fermi function for a P type TFT, $\phi FN$ represents a fermi function for an N type TFT, and ND and NA represent equivalent donor and acceptor densities for the channel regions, respectively. Further, equivalent donor and acceptor densities are determined by the density of the donor impurities existing in the region, the density of the acceptor impurities and the trap density acting as donor and acceptor. According to the present invention, the thickness of the silicon thin film of the channel region in a P type TFT and an N type TFT is formed to be smaller than either $X_{PMAX}$ or $X_{NMAX}$. Figure 7 is a cross sectional view of a TFT where a depletion layer is formed. An insulating substrate 146 carries a silicon thin film region 147 forming a channel region, and silicon thin film regions 148, 149 forming source/drain regions. A gate insulating film layer 150 is formed on the regions 147, 148 and 149, and a gate electrode 151 is provided on the layer 150. The thickness of the silicon thin film is indicated by tsi, and the width of the depletion layer formed on the silicon thin film surface is indicated by x.

The basic criteria for providing the preferred drive circuit for an active matrix panel are thus established as follows:-

(1) Each drive circuit is given a static form composed of complementary TFTs.
(2) A method of manufacture and a structure for a complementary TFT integrated circuit are provided.
(3) The characteristics of the P type and of the N type semi-conductors are made to be well balanced.
(4) The TFT design is improved so as to enhance the capacity for driving the load.

Various further improvements will now be described.

A first modification in the form of a layout for an active matrix panel is shown in Figure 8, which is a plan view of an active matrix panel 160 showing the layout of each of the circuit blocks. A source line drive circuit 161 (and/or 162) is formed at the periphery of the active matrix panel 160 at the top (and/or bottom) as illustrated, in order to form a normal image, and a shift register 163, a buffer 164, a video signal bus 165 and a sample hold circuit 166 are arranged one inside the other relative to the periphery within the source line drive circuit 161. A gate line drive circuit 167 (and/or 170) is formed at the left (and/or the right) hand periphery of the active matrix panel 160 and a shift register 168 and a buffer 169 are arranged in order inwardly from the periphery within the gate line drive circuit. A picture element matrix 171 is formed at the centre of the active matrix panel 160 for connection to the source line drive circuit 161 (162) and the gate line drive circuit 167 (170), and input terminals 172, 173, 174 and 175 are arranged at the corners of the panel. Signals are transmitted within the panel in use in the directions indicated by arrows 176 to 180. Limited space can be put to the most effective practical use by the layout as described above.

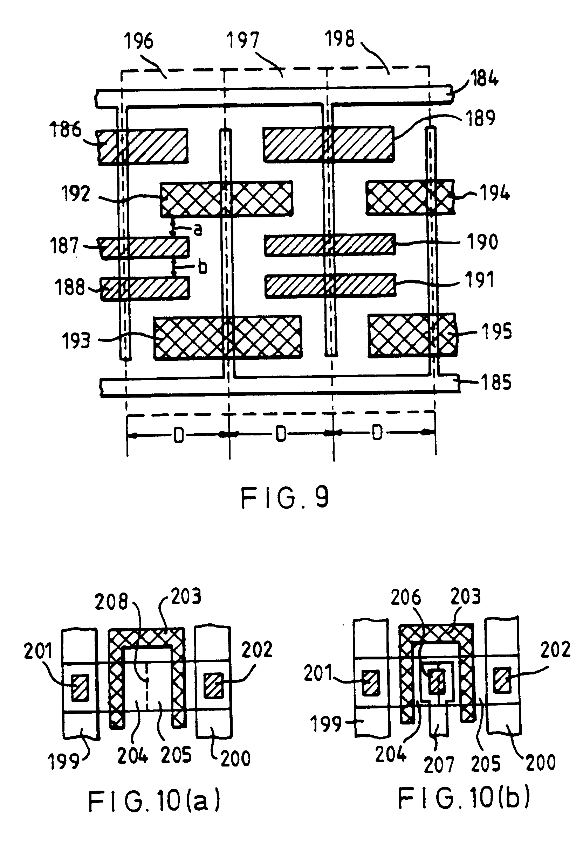

Further, a layout as shown in Figure 9 is utilised within the source line drive circuit and/or the gate line drive circuit for forming unit cells within a limited dimension equivalent to the spacing between picture elements (or twice such spacing). In Figure 9 the cells 196 to 198 have a width D corresponding to the spacing between picture elements (or twice such spacing). Arranging the drive circuit in repeating cells having a cell width D, while also employing the layout in Figure 8 makes effective use of the overall space available. In Figure 9, the cells 196 to 198 are shown surrounded by broken lines. A positive power source line 184 and a negative power source line 185 are connected to regions 186 to 191 of silicon thin film forming the source/drain and channel regions of a P type TFT and to regions 192 to 195 of silicon thin film forming the source/drain and channel regions of an N type TFT. The elements of each TFT can be separated by etching the silicon thin film to form isolated areas regardless of homo-polarity and hetero-polarity. Therefore, for instance, a distance $\underline{a}$ between the region 192 of silicon thin film of the N type TFT and the region 187 of silicon thin film of the P type TFT and a distance $\underline{b}$ between the two regions 187 and 188 of silicon thin film of the P type TFT can be made substantially equal to each other. According to the invention, the number of elements in the direction in which a unit cell is repeated can be increased by arranging an isolated area of silicon thin film of the P type TFT and an isolated area of silicon thin film of the N type TFT alternately, utilising the above characteristics positively.

In order to increase the number of elements further, the following means may also be employed. Figures 10 (a) and 10 (b) illustrate an inverter composed of complementary TFTs and formed between a positive power source line 199 and a negative power source line 200 In Figures 10 (a) and 10 (b), through holes 201 and 202 are provided for forming contact between a source region and a gate electrode 203. At first, a P type region 204 and an N type region 205 are provided in an isolated area of silicon thin film with a boundary 208. Next, a contact with the drain region is formed by a through hole 206 and an output line 207 for the inverter is added.

A second modification of the invention concerns the reduction of clock noise in the source line drive circuit. As shown in Figure 1, the source line drive circuit 12 is provided with video signal buses 14 to 16 and a line (connected to the terminal 34) for transmitting at least a pair of relatively inverted clock signals CL and $\overline{CL}$ for driving the shift register 13. The line shown connected to the terminal 34 is in fact a pair of lines and if there is a difference between the stray capacitance formed between any video signal bus and the CL line and that formed between the same video signal bus and the $\overline{CL}$ line, noise in the form of a spike synchronised with the clock signal is added to the video signal. As a result, unevenness occurs in the display in the form of a line in the picture produced by the active matrix panels.

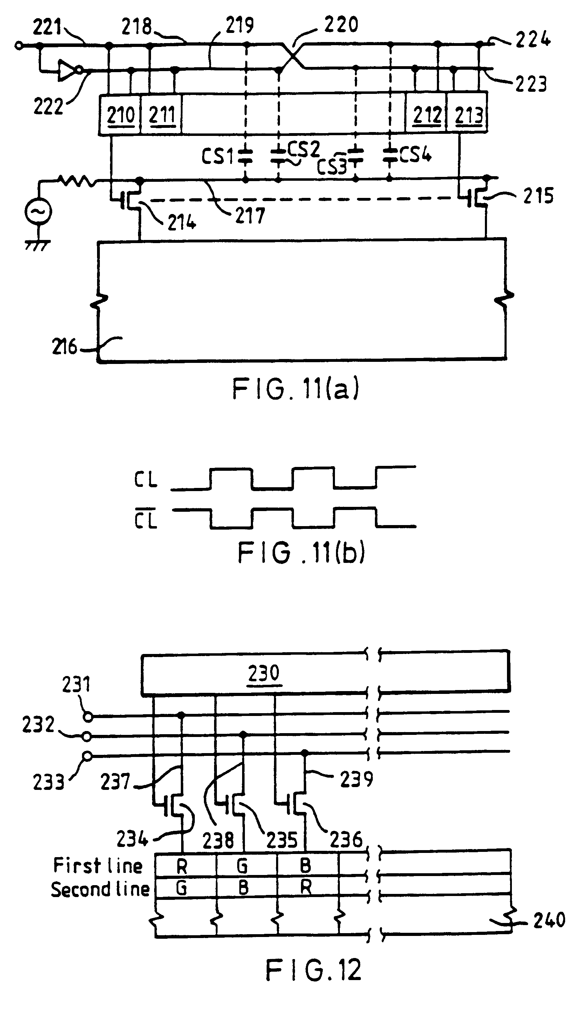

As shown in Figure 11 (a), the above described clock noise may be reduced by a twisted arrangement for the CL and $\overline{CL}$ lines. Figure 11 (a) illustrates a source line drive circuit comprising a shift register having unit cells 210 to 213, a sample hold circuit comprising TFTs 214, 215, a picture element matrix 216, and a video signal bus 217. CL and $\overline{CL}$ lines 218 and 219 cross each other (i.e. are twisted) at their centres approximately. Hence, the average distance between the CL line 218 and the video signal bus 217 and the average distance between the $\overline{CL}$ line 219 and the video signal bus 217 are made to be approximately equal to each other. As a result, the value for the stray capacitance (CS1 + CS3) which is formed between the CL line 218 and the video signal bus 217 is made to be equal to the value for the stray capacitance (CS2 + CS4) which is formed between the $\overline{CL}$ line 219 and the video signal bus 217. Further, as shown in Figure 11 (b), the rising edge of the clock signal CL corresponds to the trailing edge of the clock signal $\overline{CL}$, and vice versa. Consquently, clock noise added to the video signal can be reduced sharply to realise a clear display in the picture. Further, the CL and $\overline{CL}$ lines may be twisted (cross over) a plural number of times.

A third modification of the invention seeks to make the resistance of the connections to the sample hold circuit uniform. Figure 12 illustrates the parts of a source line drive circuit such as the one shown in Figure 1, including a shift register 230, video signal buses 231 to 233, a sample hold circuit comprising TFTs 234 to 236, and a picture element matrix 240. Picture element signals corresponding, for example, to the primary colours red (R), green (G) and blue (B), are transmitted to the three video signal buses 231 to 233 and then the combination is changed by a single horizontal scan. Since these three video signal buses require a low resistance, a metal such as aluminium is preferably used for each line. On the other hand, when the structure of Figures 3 (a) or 3 (b) which is considered to be the most effective from an economical point of view is adopted, the same material as that employed for the gate electrodes 80 and 81, such as poly-crystalline thin film, is used for lines 237 to 239 from the video signal buses to the sample hold circuit. In this case, the sheet resistance of poly-crystalline silicon thin film is much higher than the resistance of the video signal buses, and the lengths of the lines 237, 238 and 239 cannot be equal to each other if these lines are straight, whereby the resistance of the lines 237 to 239 also will not be equal to each other. As a result, the picture displayed may be uneven and include lines. However, in the present invention, the lines 237, 238 and 239 are formed such that their resistances are made equal to each other. For example, the line width W may be kept constant and the line length L of each line 237 to 239 may be made equal, or the line length L of each line may differ and the line width W may vary respectively between the lines 237 to 239.

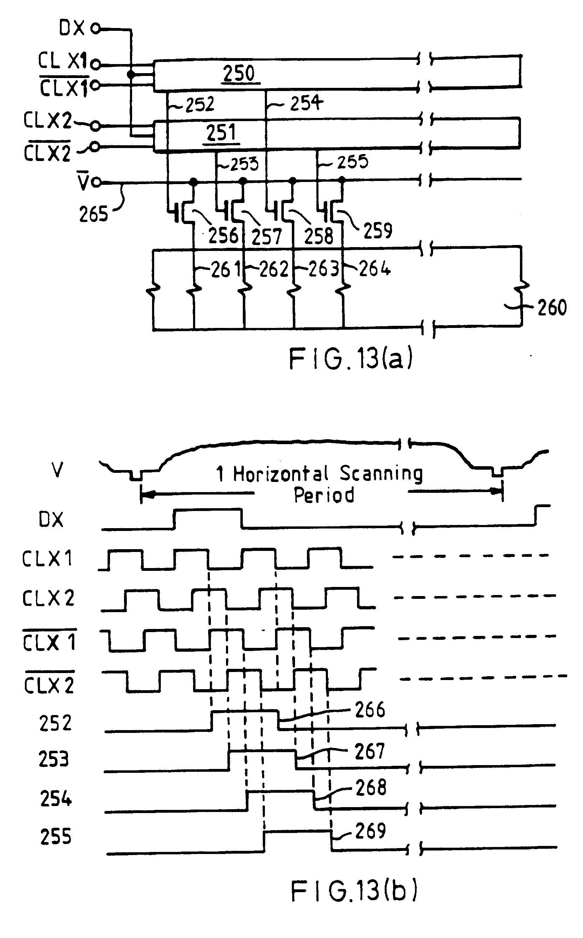

A fourth modification of the invention is directed towards increasing the slow speed of a drive circuit composed of TFTs. As shown in Figure 5, since the performance of a TFT is inferior to the performance of mono-crystalline silicon MOSFET, the speed of a shift register made from TFTs is not fast enough to drive an active matrix panel. In order to make up for this slow speed, the circuit structure as shown in Figure 13 (a) and operation as shown in Figure 13 (b) may be utilised.

In Figure 13 (a), a start signal DX and clock signals CL x 1 and $\overline{CL \times 1}$ are applied to a first shift register 250 included in a source line drive circuit for generating sampling pulses 252, 254 and so on. Further, a start signal DX and clock signals CL x 2 and $\overline{CL \times 2}$ are applied to a second shift register 251 included in the source line drive circuit for generating sampling pulses 253, 255 and so on. A video signal bus 265 is connected by way of TFTs 256 to 259 of a sample hold circuit and source lines 261 to 264 to a picture element matrix 260. The signals V, DX, CL x 1, $\overline{\text{CL x 1}}$, CL x 2, $\overline{\text{CL x 2}}$, and the pulses 252 to 255 output from the shift registers 250 and 251 are shown in Figure 13 (b).

The source line drive circuit shown in Figure 13 (a) is provided with the two shift registers 250 and 251, which are driven by clock signals CL x 1 $\overline{\text{(CL x 1)}}$ and CL x 2 $\overline{\text{(CL x 2)}}$ which are approximately 90° out of phase. When the source line drive circuit is provided with a number N of shift registers, each shift register should be driven by a respective clock signal and the inverted clock signal wherein the phases lag by approximately 180°/N. If the frequency of CL x 1 and CL x 2 is taken as f, the sampling pulses 252 to 255 are generated sequentially at intervals of 1/4f hours. The video signal V is sampled at the trailing edges 266 to 269 of the sampling pulses and is held at the source lines 261 to 264. As a result, sampling with a frequency 4f is realised by means of shift registers which are driven by a clock signal of frequency f, which results in an effective compensation for the slow speed of a shift register made up of TFTs. When the above described source line drive circuit is provided with a number N of shift registers, sampling with a frequency 2Nf can be realised by means of shift registers which are driven by a clock signal of frequency f.

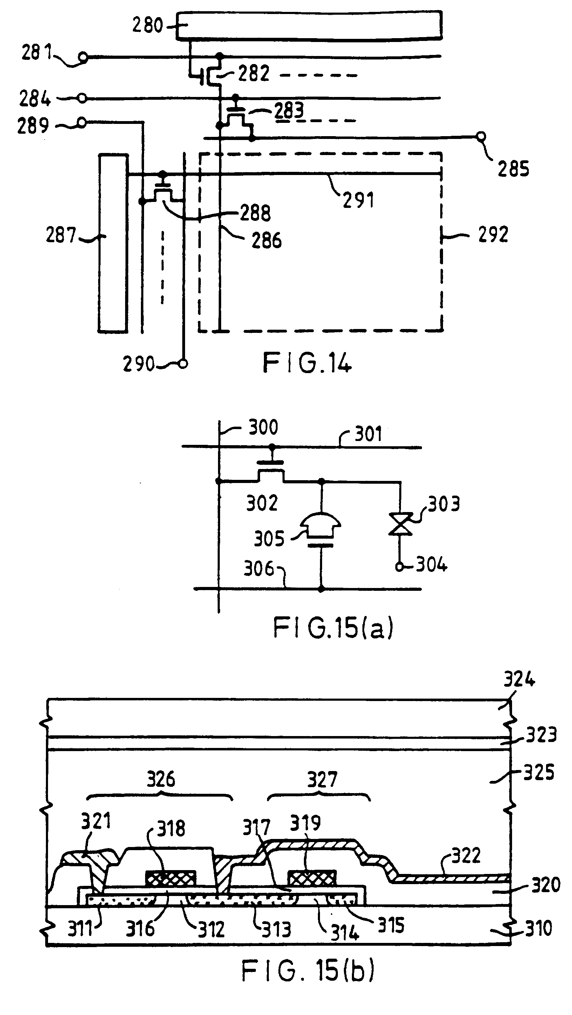

A fifth modification of the invention provides means for testing each output from the source line and gate line drive circuit. Figure 14 illustrates this modification, which includes a shift register 280 as part of the source line drive circuit, a video signal bus terminal 281, a sample and hold circuit comprising a TFT 282, a source line drive test circuit 283, a control terminal for the test circuit 283, a test signal output terminal 285 and a source line 286. A respective test circuit 283 is added to each source line 286. Likewise, a shift register 287 forming part of a gate line drive circuit is connected to a gate line test circuit 288 having a test signal input terminal 289 and a test signal output terminal 290. A gate line 291 leads from the gate line drive circuit to a picture element matrix 292. A respective test circuit 288 is added to each gate line 291.

The test circuits operate as follows: the test circuit 283 is turned ON by way of the terminal 284 for testing operation of the source line drive circuit. In this condition, the shift register 280 is scanned after a predetermined test signal is supplied to the video signal bus terminal 281. At this time, if a signal which meets standard requirements is serially output at the test output terminal 285, the result is considered as "Good" and, if not, it is considered as "Poor". For testing the gate line drive circuit, the shift register 287 is likewise scanned when a predetermined test signal is input. At this time, if a signal which meets standard requirements is serially output at the test output terminal 290, the gate line drive circuit is considered as "Good" and, if not, it is considered as "Poor". In this way, electrical testing of an active matrix panel, can be done automatically, whereas in the prior art testing has been by visual observation of a displayed test pattern.

A sixth modification of the invention involves providing a storage capacitor in a picture element without an additional process during manufacture. Figure 15 (a) illustrates the circuit of such a picture element, and Figure 15 (b) is a cross section through the picture element. As shown in Figure 15 (a), the picture element comprises a TFT 302, which operates as a switch and which is connected to a source line 300 and a gate line 301, a liquid crystal cell 303, a counter electrode terminal 304, a metal oxide semi-conductor capacitor 305 (hereinafter referred to as a MOS capacitor) having a gate electrode 306. Turning to Figure 15 (b), transparent insulating substrates 310 and 324 have sandwiched therebetween silicon thin film regions 311 to 315, gate insulating film regions 316 and 317, gate electrodes 318 and 319, an insulating film layer 320, a line layer 321 which forms a source line, a transparent conductive film layer 322 which forms a picture element electrode, a counter electrode 323 including a transparent conductive film layer, and a layer of liquid crystal material 325.

The TFT 302 formed by the portion indicated by the reference numeral 326, the regions 311 and 313 providing the source/drain regions thereof and the region 312 forming the channel region. The MOS capacitor 305 is formed by the portion indicated by the reference numeral 327, with the regions 313 and 315 providing the source/drain regions thereof and the region 314 forming the channel region thereof.

As shown clearly in Figure 15 (b), since the MOS capacitor 305 has entirely the same cross sectional structure as the TFT 302, it is not necessary to add any special extra manufacturing process in order to form the MOS capacitor 305. However, if the MOS capacitor 305 is to be used as a storage capacitor, it is necessary to maintain a condition wherein a channel, that is an inversion layer, is formed at the region 314. A predetermined voltage potential is applied to the gate electrode 306 (319) of the MOS capacitor 305 so as to turn the latter on for maintaining this condition. For example, a positive potential in the case of an N type MOS capacitor or a negative potential in the case of a P type MOS capacitor is appropriate for this. Since a gate insulating film is normally formed to be extremely thin, a storage capacitor produced as described above can be from five to ten times as large as a storage capacitor making use of a conventional insulating film layer. This is very effective for economising on the area employed by the storage capacitor. Therefore, it becomes possible to increase the aperture ratio of the active matrix panel.

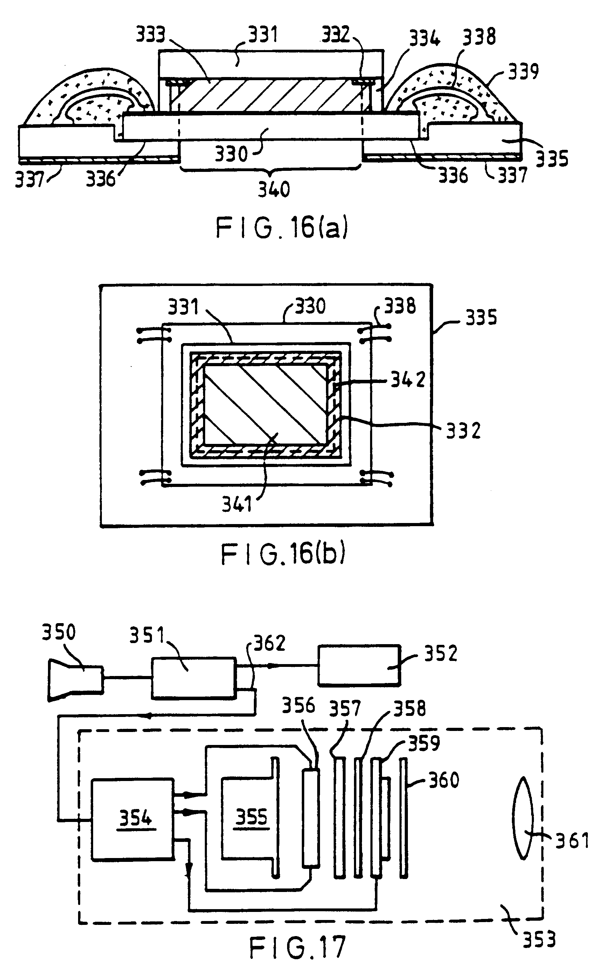

A last modification of the invention concerns the mounting of an active matrix panel having a built-in drive circuit. Figure 16 (a) is a cross section through an arrangement for the mounting, which features a transparent substrate 330 wherein a picture element matrix and a drive circuit composed of TFTs are formed, a transparent substrate 331 wherein a counter electrode is formed, a sealing member 334, a filling of liquid crystal material 333, a mounting substrate 335 having an aperture 340, a wire 338 made of a metal such as gold or aluminium, and a protective member 339. A recess 336 in the mounting substrate 335 adjacent the aperture 340 is effective for ensuring a strong connection by the wire 338. A shading member 337 is advantageously provided over all or a part of the mounting substrate 335, and a further shading member 332 in the form of a strip surrounding a portion of the picture element matrix is advantageously provided on the transparent substrate 330 for improving the external appearance of the active matrix panel when used as a display device. Figure 16 (b) is a plan view of the arrangement showing the picture element matrix 341 supported by the mounting substrate 335 over the aperture, which is indicated by the dotted line 342.

Since the stress on the wire 338 is uniform with this arrangement, the strength of the connection is improved. Further, when the active matrix panel in accordance with this embodiment is utilised as a transmission type display device and a light source is provided at its rear face, the leakage of unnecessary light from the periphery of the picture element matrix can be prevented and an improved external appearance is obtained.

Two applications of the invention will now be described.

A first application of the invention is in an electric view finder (hereinafter referred to as an EVF) of a video camera or the like. By integrating a drive circuit made of complementary TFTs with the picture element matrix as described above, a small, inexpensive and reliable active matrix panel having a low power consumption and a high resolution density can be obtained. As a result an EVF having the structure shown in Figure 17 can be realised. This EVF 353 is connected to an image sensing device 350, recording apparatus 352, and a video signal processing circuit 351 arranged to supply a composite video signal on a line 362. The EVF 353 comprises a drive circuit 354, including a chroma circuit, a synchronised timing signal formation circuit, a liquid crystal panel driving signal formation circuit, a power source and a back light driving circuit. The EVF further comprises a light source 356 for providing the back light, a reflector 355, a diffuser 357, polarisers 358 and 360, an active matrix panel 359 according to the invention and a lens 361.

Such a structure offers the following benefits, which have not been obtained by an EVF employing a conventional cathode ray tube.

(1) A colour EVF having an extremely high resolution with a picture element spacing of 50 microns and less can be produced if the active matrix panel is provided with a colour filter. Low power consumption is also promoted.
(2) An extremely small, light weight, space saving design of EVF can be realised.
(3) The shape of the EVF can be more freely chosen, and even a novel design in which the EVF is flat is possible.

Another application is in a colour display projector, in which the active matrix panel is employed as a liquid crystal light valve. Figure 18 is a plan view of such a colour display projector. White light emitted from a light source 370, such as a halogen lamp, is condensed by a parabolic mirror 371 and is filtered to cut out heat rays in the infra-red region by heat ray cutting filter 372 so that only light rays in the visible spectrum enter the dichroic mirror system of the projector. First, blue light (light having a wavelength of about 500 nm) is reflected by a blue light reflection dichroic mirror 373, other light (e.g. yellow light) being transmitted therethrough. The reflected blue light is directed by a reflection mirror 374 into a blue light modulation liquid crystal light valve 378. The light transmitted through the blue light reflection dichroic mirror 373 strikes a green light reflection dichroic mirror 375, and green light (light having a wavelength of about 500 nm to 600 nm) is reflected while the other light, that is red light (light having a wavelength of about 600 nm and longer), is transmitted therethrough. The reflected green light enters a green light modulation liquid crystal light valve 379. The red light transmitted through the green light reflection dichroic mirror 375 is directed by reflection mirrors 376 and 377 into a red light modulation liquid crystal valve 380.

The blue light, green light and red light are modulated by the liquid crystal light valves 378, 379 and 380, each of which comprises an active matrix panel according to the invention driven by a primary colour signal, such as blue, green and red, and are then synthesised by a dichroic prism 383. The dichroic prism 383 is so constructed that a blue light reflection surface 381 and a red light reflection surface 382 cross one another at right angles. The thus synthesised colour image is magnified and projected onto a screen by a projection lens 384.

Such a structure offers the following benefits, which have not been obtained by a colour display projector employing a conventional cathode ray tube as a projection tube.

(1) A projection lens with a small aperture can be used for the projection lens 384 because the liquid crystal light valve can be made smaller and of higher resolution than is possible with a cathode ray tube. Therefore, a small, light weight and inexpensive projector can be realised.
(2) Having a high aperture ratio, the active matrix panel of the invention permits a light display even if a projection lens with a small aperture is utilised.
(3) Good registration of the three colours can be obtained because the optical axes of the red, green and blue light valves are fully aligned relative to each other by the dichroic mirrors and dichroic prisms.

The present invention, therefore, provides a number of benefits and advantages.

Firstly, the following advantages can be obtained by forming the gate line/source line drive circuit made of complementary TFTs on the same transparent substrate as the picture element matrix in accordance with the invention.

(1) In the prior art, the degree of resolution is limited by the mounting of the drive integrated circuit. This limitation is removed by the built-in drive integrated circuit of the invention. As a result, a liquid crystal panel having a picture element spacing of 500 microns and less can be obtained in accordance with the invention.
(2) The external dimension of the mounting substrate of the matrix panel can be miniaturised so that a display device employing a liquid crystal panel according to the invention can be made smaller, thinner and lighter.
(3) Since the step of attaching an external drive integrated circuit is unnecessary, a low cost display device can be obtained.
(4) Since the connection of an external drive integrated circuit is not required, the reliability of the display device can be improved.
(5) The low current consumption which is an intrinsic feature of the present active matrix panel obtained by forming the drive circuit with complementary TFTs results in low current consumption in the whole display device. This is an important feature, which makes the application of the invention in an EVF for a video camera and a portable image monitor feasible.

Secondly, not only is low power consumption achieved but also the voltage range and operating frequency range can be extended by the use of complementary TFTs and a circuit structure with a static type of shift register. A TFT has a high OFF current characteristic as shown in Figure 5 and the temperature dependency of the OFF current is also large. This defect of the TFT is compensated by a static type of shift register, and so the voltage range and frequency range can be expanded.

Thirdly, due to the structure wherein first polar impurities are included in the first polar TFT source/drain region and both first and second polar impurities, with the latter having a higher density than the former, are included in the second polar TFT source/drain region, an inexpensive complementary TFT integrated circuit can be obtained by the addition of a single photo process to the conventional process for manufacturing a known mono-conductive type TFT. Further, P type and N type TFTs with well balanced performances can thus be obtained.

Fourthly, the gate which forms the drive circuit is formed to be shorter than that of the TFT which forms the picture element matrix, so that the actuating speed of the drive circuit can be improved and the writing and holding of electric charge in each picture element can be maintained in the optimum condition.

Further, the various modifications of the invention described above provide the following beneficial effects.

Firstly, the pattern layout as shown in Figures 8, 9, 10 (a) and 10 (b) enhances the arrangement within the drive circuit(s) so that unit cells can be formed within a defined pitch corresponding to the spacing of the picture elements.

Secondly, clock noise in the video signals can be removed to the point of rendering any corresponding unevenness or unwanted line in the picture displayed below the level of visibility.

Thirdly, the resistances of the connections to the sample and hold circuit are made uniform along each source line so that the writing level of the display signal to all the source lines is rendered uniform, which avoids unevenness in the form of a line in the picture display.

Fourthly, the source line drive circuit as shown in Figure 13 (a) and driven by the signals as shown in Figure 13 (b) allow sampling of the video signal with a frequency 2Nf by means of a system of N shift registers which are driven by a clock signal having a frequency f. Therefore, an active matrix panel having a built-in drive circuit of high resolution can be obtained even when TFTs, whose ON current is not necessarily large enough, are employed.

Fifthly, by providing a test circuit for the output of each drive circuit, checking the active matrix panel, which has previously been carried out by visual examination of a display test pattern, can be carried out electrically and automatically.

Sixthly, the structure for a storage capacitor as shown in Figures 15 (a) and 15 (b) may be employed in each picture element to hold the electric charge in each picture element more steadily but without either increasing the cost of production or decreasing the aperture ratio.

Seventhly, the mounting structure as shown in Figures 16 (a) and 16 (b) not only improves the connection strength and the reliability of the panel but also prevents the leakage of unnecessary light around the periphery of the picture element matrix in the event that back lighting is used with the active matrix panel of the invention to construct a transparent display device.

Finally, the application of the invention to the particular display systems described has the following advantages.

Firstly, effects which cannot be obtained by the use of a conventional cathode ray tube in an EVF can be obtained by the application of the invention to the EVF of a video camera.

(1) An extremely high resolution colour EVF with a picture element spacing of 50 microns or less can be realized by the use of an active matrix panel which is provided with a colour filter. Further, low power consumption results.

(2) An extremely small and light weight EVF can be realized in a space saving manner.

(3) The shape of the EVF can be selected more freely so that a novel design, for example a flat EVF, can be provided.

Secondly, effects which cannot be obtained by the use of a conventional cathode ray tube can be obtained by the application of the invention to a colour display projector.

(1) Since the liquid crystal valve can be made smaller and of higher resolution than in the case of the cathode ray tube, a projection lens with a small aperture can be used. Therefore, a small, light weight and inexpensive colour display projector can be realised.

(2) Due to the high aperture ratio of the active matrix panel, light display can be obtained even with a projection lens with a small aperture.

(3) Unlike the projection tube employing the cathode ray tube, the optical axes of the light valves for each colour, namely red, green and blue, can be made to coincide by the dichroic mirrors and dichroic prisms so that the registration of the three colours can be achieved satisfactorily.

## Claims

1. An active matrix panel comprising a picture element matrix (22), which is mounted on a transparent substrate (71, 86) and which includes a plurality of gate lines (24, 25), a plurality of source lines (26, 27, 28) and a plurality of picture elements (32, 33), each of the picture elements including a polycrystalline silicon thin film transistor (29, 101), the active matrix panel further comprising a gate line drive circuit (21) and a source line drive circuit (12) and being characterised in that at least one of the gate line drive circuit and the source line drive circuit comprises a static shift register, the static shift register comprising at least one clocked-inverter and a plurality of unit cells (196, 197, 198), the unit cells each having a width and comprising a plurality of power source lines (184, 185) and a plurality of thin film transistors (47 to 56; 58, 59; 99, 100) provided on the transparent substrate, the plurality of thin film transistors including P-type polycrystalline silicon thin film transistors and N-type polycrystalline silicon thin film transistors, respective power source lines being connected to the P-type transistors and the N-type transistors, and the P-type transistors and the N-type transistors being arranged alternately in the unit cell with respect to the width thereof; and the at least one clocked-inverter receiving a clock signal and outputting an inverted clock signal.

2. An active matrix panel comprising a picture element matrix (22), which is mounted on a transparent substrate (71, 86) and which includes a plurality of gate lines (24, 25), a plurality of source lines (26, 27, 28) and a plurality of picture elements (32, 33), each of the picture elements including a polycrystalline silicon thin film transistor (29, 101), the active matrix panel further comprising a gate line drive circuit (21) and a source line drive circuit (12) and being characterised in that at least one of the gate line drive circuit and the source line drive circuit comprises a static shift register, the static shift register comprising an inverter and transmission gate circuit, the transmission gate circuit receiving a clock signal and outputing an inverted clock signal and including a plurality of polycrystalline silicon complementary thin film transistors (47 to 56; 58, 59; 99, 100) provided on the transparent substrate.

3. A panel according to claim 1 or claim 2, characterised in that the gate line drive circuit (167) comprises a shift register (168) and a buffer (169) arranged in that order with the buffer closer to the picture element matrix.

4. A panel according to any preceding claim, characterised in that the source line drive circuit includes a sample and hold circuit (166).

5. A panel according to any preceding claim, wherein the shift register of at least one of the gate line drive circuit and the source line drive circuit is in the CMOS configuration and includes polycrystalline silicon thin film transistors of P type and N type, each having a separating region for separating source and drain, the separating region of the P type transistor having a thickness which is less than a maximum calculated depletion layer thickness $X_{PMAX}$, and the separating region of the N type transistor having a thickness which is less than a maximum calculated depletion layer thickness $X_{NMAX}$, where:

$$X_{PMAX} = (2\varepsilon \times 2 \phi fP)^{\frac{1}{2}} \times (q \times ND)^{-\frac{1}{2}}$$

$$X_{NMAX} = (2\varepsilon \times 2 \phi fN)^{\frac{1}{2}} \times (q \times NA)^{-\frac{1}{2}}$$

q =     a unit of electric charge,

$\epsilon$ =     the dielectic constant of a thin silicon film

$\phi$fP =     the fermi energy of a P type TFT,

$\phi$fN =     the fermi energy of an N type TFT,

ND =     equivalent donor density of the thin silicon film formed between the associated gate insulating layer and the substrate,

NA =     equivalent acceptor density of the thin silicon film formed between the associated gate insulating layer and the substrate.

6.   A drive circuit for an active matrix panel comprising at least a gate line drive circuit (21) and a source line drive circuit (12) and being characterised in that at least one of the gate line drive circuit and the source line drive circuit comprises a static shift register, the static shift register comprising at least one clocked-inverter and being composed of a plurality of polycrystalline silicon complementary thin film transistors (47 to 56; 58, 59; 99, 100) provided on the transparent substrate, the at least one clocked-inverter receiving a clock signal and outputing an inverted clock signal.

7.   A drive circuit for an active matrix panel comprising at least a gate line drive circuit (21) and a source line drive circuit (12) and being characterised in that at least one of the gate line drive circuit and the source line drive circuit comprises a static shift register, the static shift register comprising an inverter and transmission gate circuit, the transmission gate circuit receiving a clock signal and outputing an inverted clock signal and including a plurality of polycrystalline silicon complementary thin film transistors (47 to 56; 58, 59; 99, 100) provided on the transparent substrate.

8.   A projection type colour display device including a light source, at least one light valve, and at least one projecting optical system for projecting an image, the at least one light valve including a plurality of liquid crystal cells, wherein signals are supplied to the plurality of liquid crystal cells through a plurality of field effect transistors arranged in a plurality of picture elements, the light valve comprising:

a picture element matrix (22), which is mounted on a transparent substrate (71, 86) and which includes a plurality of gate lines (24, 25), a plurality of source lines (26, 27, 28) and a plurality of picture elements (32, 33) each of the picture elements including a thin film transistor (29, 101), the active matrix panel further comprising a gate line drive circuit (21) and a source line drive circuit (12) and being characterised in that at least one of the gate line drive circuit and the source line drive circuit comprises a static shift register, the static shift register comprising at least one clocked-inverter and being composed of a plurality of polycrystalline silicon complementary thin film transistors (47 to 56; 58, 59; 99, 100) provided on the transparent substrate, the at least one clocked-inverter receiving a clock signal and outputing an inverted clock signal.

9.   A projection type colour display device including a light source, at least one light valve, and at least one projecting optical system for projecting an image, the at least one light valve including a plurality of liquid crystal cells, wherein signals are supplied to the plurality of liquid crystal cells through a plurality of field effect transistors arranged in a plurality of picture elements, the light valve comprising:

a picture element matrix (22), which is mounted on a transparent substrate (71, 86) and which includes a plurality of gate lines (24, 25), a plurality of source lines (26, 27, 28) and a plurality of picture elements (32, 33) each of the picture elements including a thin film transistor (29, 101), the active matrix panel further comprising a gate line drive circuit (21) and a source line drive circuit (12) and being characterised in that at least one of the gate line drive circuit and the source line drive circuit comprises a static shift register, the static shift register comprising an inverter and transmission gate circuit, the transmission gate circuit receiving a clock signal and outputing an inverted clock signal and including a plurality of polycrystalline silicon complementary thin film transistors (47 to 56; 58, 59; 99, 100) provided on the transparent substrate.

**Patentansprüche**

1.   Aktivmatrixfeld, umfassend eine Bildelementmatrix (22), welche auf einem transparenten Substrat (71, 86) angebracht ist, und welche umfaßt: eine Mehrzahl von Gate-Leitungen (24, 25), eine Mehrzahl von Source-Leitungen (26, 27, 28) und eine Mehrzahl von Bildelementen (32, 33), wobei jedes der Bildelemente einen polykristallinen Silizium-Dünnfilm-Transistor (29, 101) umfaßt, wobei das Aktivmatrixfeld ferner einen Gate-Leitungs-Treiberschaltkreis (21) und einen Source-LeitungsTreiberschaltkreis (12) umfaßt, und **dadurch gekennzeichnet** ist, daß der Gate-Leitungs-Treiberschaltkreis oder/und der Source-Leitungs-Treiberschaltkreis ein statisches Schieberegister aufweist, wobei das statische Schieberegister wenigstens einen getakteten Inverter umfaßt und aus einer Mehrzahl komplementärer polykristalliner Silizium-Dünnfilm-Transistoren (47 bis 56; 58, 59; 99, 100) gebildet ist, weiche auf dem transparenten Substrat vorgesehen sind, wobei der wenigstens eine getaktete Inverter ein Taktsignal aufnimmt und ein invertiertes Taktsignal ausgibt.

2. Aktivmatrixfeld, umfassend eine Bildelementmatrix (22), welche auf einem transparenten Substrat (71, 86) angebracht ist und welche eine Mehrzahl von Gate-Leitungen (24, 25) eine Mehrzahl von Source-Leitungen (26, 27, 28) und eine Mehrzahl von Bildelementen (32, 33) umfaßt, wobei jedes der Bildelemente einen polykristallinen Silizium-Dünnfilm-Transistor (29, 101) aufweist, wobei das Aktivmatrixfeld ferner einen Gate-Leitungs-Treiberschaltkreis (21) und einen Source-Leitungs-Treiberschaltkreis (12) umfaßt und **dadurch gekennzeichnet** ist, daß der Gate-Leitungs-Treiberschaltkreis oder/und der Source-Leitungs-Treiberschaltkreis ein statisches Schieberegister aufweist, wobei das statische Schieberegister einen Inverter und einen Übertragungs-Gate-Schaltkreis umfaßt, wobei der Übertragungs-Gate-Schaltkreis ein Taktsignal aufnimmt und ein invertiertes Taktsignal ausgibt und eine Mehrzahl von komplementären polykristallinen Silizium-Dünnfilm-Transistoren (47 bis 56; 58, 59; 99, 100) umfaßt, welche auf dem transparenten Substrat vorgesehen sind.

3. Feld nach Anspruch 1 oder Anspruch 2, **dadurch gekennzeichnet**, daß der Gate-Leitungs-Treiberschaltkreis (167) ein Schieberegister (168) und einen Puffer (169) umfasst, welche in der Reihenfolge angeordnet sind, daß der Puffer näher zur Bildelementmatrix liegt.

4. Feld nach einem der vorangehenden Ansprüche, **dadurch gekennzeichnet**, daß der Source-Leitungs-Treiberschaltkreis einen Abtast- und Halteschaltkreis (166) umfaßt.

5. Feld nach einem der vorangehenden Ansprüche, wobei das Schieberegister des Gate-Leitungs-Treiberschaltkreises oder/und des Source-Leitungs-Treiberschaltkreises eine CMOS-Konfiguration besitzt und polykristalline Silizium-Dünnfilm-Transistoren des P-Typs und des N-Typs aufweist, von denen jeder einen Trennbereich zum Trennen von Quelle und Dran aufweist, wobei der Trennbereich des P-Typ-Transistors eine Dicke besitzt, die kleiner als eine maximal berechnete Sperrschichtdicke $X_{PMAX}$ ist, und wobei der Trennbereich des N-Typ-Transistors eine Dicke aufweist, welche kleiner als eine maximal berechnete Sperrschichtdicke $X_{NMAX}$ ist, wobei

$$X_{PMAX} = (2\varepsilon \times 2 \phi FP)^{1/2} \times (q \times ND)^{-1/2}$$

$$X_{NMAX} = (2\varepsilon \times 2 \phi FN)^{1/2} \times (q \times NA)^{-1/2}$$

q = eine Einheit einer elektrischen Ladung,
$\varepsilon$ = die Dielektrizitätskonstante eines dünnen Siliziumfilms
$\phi$ fP = die Fermi-Energie eines P-Typ-TFTs,
$\phi$ fN = die Fermi-Energie eines N-Typ-TFTs,
ND = die äquivalente Donatordichte des dünnen Siliziumfilms, welcher zwischen der zugeordneten Gate-isolierenden Schicht und dem Substrat ausgebildet ist,
NA = die äquivalente Akzeptordichte des zwischen der zugeordneten Gate-isolierenden Schicht und dem Substrat ausgebildeten dünnen Siliziumfilms.

6. Treiberschaltkreis für ein Aktivmatrixfeld, umfassend wenigstens einen Gate-Leitungs-Treiberschaltkreis (21) und einen Source-Leitungs-Treiberschaltkreis (12) und **dadurch gekennzeichnet**, daß der Gate-Leitungs-Treiberschaltkreis oder/und der Source-Leitungs-Treiberschaltkreis ein statisches Schieberegister aufweist, wobei das statische Schieberegister wenigstens einen getakteten Inverter umfaßt und aus einer Mehrzahl komplementärer polykristalliner Silizium-Dünnfilm-Transistoren (47 bis 56; 58, 59; 99, 100) gebildet ist, welche auf dem transparenten Substrat vorgesehen sind, wobei der wenigstens eine getaktete Inverter ein Taktsignal aufnimmt und ein invertiertes Taktsignal ausgibt.

7. Treiberschaltkreis für ein Aktivmatrixfeld, umfassend wenigstens einen Gate-Leitungs-Treiberschaltkreis (21) und einen Source-Leitungs-Treiberschaltkreis (12) und **dadurch gekennzeichnet**, daß der Gate-Leitungs-Treiberschaltkreis oder/und der Source-Leitungs-Treiberschaltkreis ein statisches Schieberegister umfaßt, wobei das statische Schieberegister einen Inverter und einen Übertragungs-Gate-Schaltkreis aufweist, wobei der Übertragungs-Gate-Schaltkreis ein Taktsignal empfängt und ein invertiertes Taktsignal ausgibt und eine Mehrzahl von polykristallinen komplementären Silizium-Dünnfilm-Transistoren (47 bis 56; 58, 59; 99, 100) umfaßt, die auf dem transparenten Substrat vorgesehen sind.

8. Projektions-Typ-Farb-Anzeigevorrichtung, umfassend eine Lichtquelle, wenigstens ein Lichtventil und wenigstens ein projizierendes optisches System zum Projizieren eines Bildes, wobei das wenigstens eine Lichtventil eine Mehrzahl von Flüssigkristallzellen umfaßt, wobei der Mehrzahl von Flüssigkristallzellen durch eine Mehrzahl von in einer Mehrzahl von Bildelementen angeordneten Feldeffekttransistoren Signale zugeführt werden, wobei das Lichtventil umfaßt:

eine Bildelementmatrix (22), welche auf einem transparenten Substrat (71, 86) angebracht ist, und welche eine Mehrzahl von Gate-Leitungen (24, 25), eine Mehrzahl von Source-Leitungen (26, 27, 28) und eine Mehrzahl von Bildelementen (32, 33) umfaßt, wobei jedes der Bildelemente einen Dünnfilmtransistor (29, 101) aufweist, wobei das Aktivmatrixfeld ferner einen Gate-Leitungs-Treiberschaltkreis (21) und einen Source-Leitungs-Treiberschaltkreis (12) umfaßt und **dadurch gekennzeichnet** ist, daß der Gate-Leitungs-Treiberschaltkreis oder/und der Source-Leitungs-Treiberschaltkreis ein statisches Schieberegister aufweist, wobei das statische Schieberegister wenigstens einen getakteten Inverter umfaßt und aus einer Mehrzahl von auf dem transparenten Substrat vorgesehenen komplementären polykristallinen Silizium-Dünnfilm-Transistoren (47 bis 56; 58, 59; 99, 100) gebildet ist, wobei der wenigstens eine getaktete Inverter ein Taktsignal aufnimmt und ein invertiertes Taktsignal ausgibt.

9. Projektions-Typ-Farb-Anzeigevorrichtung, umfassend eine Lichtquelle, wenigstens ein Lichtventil und wenigstens ein projizierendes optisches System zum Projizieren eines Bildes, wobei das wenigstens eine Lichtventil eine Mehrzahl von Flüssigkristall-Zellen umfaßt, wobei der Mehrzahl von Flüssigkristall-Zellen durch eine Mehrzahl von in einer Mehrzahl von Bildelementen angeordneten Feldeffekttransistoren Signale zugeführt werden, wobei das Lichtventil umfaßt:

eine Bildelementmatrix (22), welche auf einem transparenten Substrat (71, 86) angebracht ist und welche eine Mehrzahl von Gate-Leitungen (24, 25), eine Mehrzahl von Source-Leitungen (26, 27, 28) und eine Mehrzahl von Bildelementen (32, 33) aufweist, wobei jedes der Bildelemente einen Dünnfilmtransistor (29, 101) umfaßt, wobei das Aktivmatrixfeld ferner einen Gate-Leitungs-Treiberschaltkreis (21) und einen Source-Leitungs-Treiberschaltkreis (12) umfaßt und **dadurch gekennzeichnet** ist, daß der Gate-Leitungs-Treiberschaltkreis oder/und der Source-Leitungs-Treiberschaltkreis ein statisches Schieberegister umfaßt, wobei das statische Schieberegister einen Inverter und einen Übertragungs-Gate-Schaltkreis aufweist, wobei der Übertragungs-Gate-Schaltkreis ein Taktsignal aufnimmt und ein invertiertes Taktsignal abgibt und eine Mehrzahl von komplementären polykristallinen Silizium-Dünnfilm-Transistoren (47 bis 56; 58, 59; 99, 100) umfaßt, die auf dem transparenten Substrat vorgesehen sind.

**Revendications**

1. Panneau de matrice active comprenant une matrice d'éléments d'image (22), qui est montée sur un substrat transparent (71, 86) et qui comprend une pluralité de lignes de grille (24, 25), une pluralité de lignes de source (26, 27, 28) et une pluralité d'éléments d'image (32, 33), chacun des éléments d'image comprenant un transistor à couches minces en silicium polycristallin (29, 101), le panneau de matrice active comprenant, de plus, un circuit de commande de ligne de grille (21) et un circuit de commande de ligne de source (12) et étant caractérisé en ce qu'au moins l'un du circuit de commande de ligne de grille et du circuit de commande de ligne de source comprend un registre à décalage statique, le registre à décalage statique comprenant au moins un inverseur commande par une horloge et étant composé d'une pluralité de transistors à couches minces complémentaires en silicium polycristallin (47 à 56 ; 58, 59 ; 99, 100) prévus sur le substrat transparent, le susdit au moins un inverseur commandé par une horloge recevant un signal d'horloge et sortant un signal d'horloge inversé.

2. Panneau de matrice active comprenant une matrice d'éléments d'image (22), qui est montée sur un substrat transparent (71, 86) et qui comprend une pluralité de lignes de grille (24, 25), une pluralité de lignes de source (26, 27, 28) et une pluralité d'éléments d'image (32, 33), chacun des éléments d'image comprenant un transistor à couches minces en silicium polycristallin (29, 101), le panneau de matrice active comprenant, de plus, un circuit de commande de ligne de grille (21) et un circuit de commande de ligne de source (12) et étant caractérisé en ce qu'au moins l'un du circuit de commande de ligne de grille et du circuit de commande de ligne de source comprend un registre à décalage statique, le registre à décalage statique comprenant un circuit d'inverseur et de porte de transmission, le circuit de porte de transmission recevant un signal d'horloge et sortant un signal d'horloge inversé et comprenant une pluralité de transistors à couches minces complémentaires en silicium polycristallin (47 à 56 ; 58, 59 ; 99, 100) prévus sur le substrat transparent.

3. Panneau selon la revendication 1 ou la revendication 2, caractérisé en ce que le circuit de commande de ligne de grille (167) comprend un registre à décalage (168) et une mémoire tampon (169) agencés dans cet ordre, la mémoire tampon étant plus proche de la matrice d'éléments d'image.

4. Panneau selon l'une quelconque des revendications précédentes, caractérisé en ce que le circuit de commande de ligne de source comprend un circuit d'échantillonnage et de maintien (166).

5. Panneau selon l'une quelconque des revendications précédentes, dans lequel le registre à décalage d'au moins l'un du circuit de commande de ligne de grille et du circuit de commande de ligne de source est de configuration CMOS et comprend des transistors à couches minces en silicium polycristallin de type P et de type N, comportant chacun une région de séparation pour séparer la source et le drain, l'épaisseur de la région de séparation du transistor de type P étant inférieure à une épaisseur de couche de déplétion calculée maximale $X_{PMAX}$, et l'épaisseur de la région de séparation du transistor de type N étant inférieure à une épaisseur de couche de déplétion calculée maximale $X_{NMAX}$, où :

$$X_{PMAX} = (2\varepsilon \times 2\,\phi fP)^{1/2} \times (q \times ND)^{-1/2}$$

$$X_{NMAX} = (2\varepsilon \times 2\,\phi fN)^{1/2} \times (q \times NA)^{-1/2}$$

q = une unité de charge électrique,
$\varepsilon$ = la constante diélectrique d'une couche mince de silicium,
$\phi fP$ = l'énergie de Fermi d'un transistor à couches minces de type P,
$\phi fN$ = l'énergie de Fermi d'un transistor à couches minces de type N,
ND = la densité de donneurs équivalente de la couche mince de silicium formée entre la couche d'isolation de grille associée et le substrat,
NA = la densité d'accepteurs équivalente de la couche mince de silicium formée entre la couche d'isolation de grille associée et le substrat.

6. Circuit de commande pour un panneau de matrice active comprenant au moins un circuit de commande de ligne de grille (21) et un circuit de commande de ligne de source (12) et étant caractérisé en ce qu'au moins l'un du circuit de commande de ligne de grille et du circuit de commande de ligne de source comprend un registre à décalage statique, le registre à décalage statique comprenant au moins un inverseur commandé par une horloge et étant composé d'une pluralité de transistors à couches minces complémentaires en silicium polycristallin (47 à 56 ; 58, 59 ; 99, 100) prévus sur le substrat transparent, le susdit au moins un inverseur commandé par une horloge recevant un signai d'horloge et sortant un signal d'horloge inversé.

7. Circuit de commande pour un panneau de matrice active comprenant au moins un circuit de commande de ligne de grille (21) et un circuit de commande de ligne de source (12) et étant caractérisé en ce qu'au moins l'un du circuit de commande de ligne de grille et du circuit de commande de ligne de source comprend un registre à décalage statique, le registre à décalage statique comprenant un circuit d'inverseur et de porte de transmission, le circuit de porte de transmission recevant un signal d'horloge et sortant un signal d'horloge inversé et comprenant une pluralité de transistors à couches minces complémentaires en silicium polycristallin (47 à 56 ; 58, 59 ; 99, 100) prévus sur le substrat transparent.

8. Dispositif d'affichage couleur de type à projection comprenant une source de lumière, au moins une valve de lumière, et au moins un système optique de projection pour projeter une image, la susdite au moins une valve de lumière comprenant une pluralité de cellules de cristaux liquides, dans lequel des signaux sont fournis à la pluralité de cellules de cristaux liquides par l'intermédiaire d'une pluralité de transistors à effet de champ agencés dans une pluralité d'éléments d'image, la valve de lumière comprenant :

une matrice d'éléments d'image (22), qui est montée sur un substrat transparent (71, 86) et qui comprend une pluralité de lignes de grille (24, 25), une pluralité de lignes de source (26, 27, 28) et une pluralité d'éléments d'image (32, 33), chacun des éléments d'image comprenant un transistor à couches minces (29, 101), le panneau de matrice active comprenant, de plus, un circuit de commande de ligne de grille (21) et un circuit de commande de ligne de source (12) et étant caractérisé en ce qu'au moins l'un du circuit de commande de ligne de grille et du circuit de commande de ligne de source comprend un registre à décalage statique, le registre à décalage statique comprenant au moins un inverseur commandé par une horloge et étant composé d'une pluralité de transistors à couches minces complémentaires en silicium polycristallin (47 à 56 ; 58, 59 ; 99, 100) prévus sur le substrat transparent, le susdit au moins un inverseur commandé par une horloge recevant un signal d'horloge et sortant un signai d'horloge inversé.

9. Dispositif d'affichage couleur de type à projection comprenant une source de lumière, au moins une valve de lumière, et au moins un système optique de projection pour projeter une image, la susdite au moins une valve de lumière comprenant une pluralité de cellules de cristaux liquides, dans lequel des signaux sont fournis à la pluralité de cellules de cristaux liquides par l'intermédiaire d'une pluralité de transistors à effet de champ agencés dans une pluralité d'éléments d'image, la valve de lumière comprenant :

une matrice d'éléments d'image (22), qui est montée sur un substrat transparent (71, 86) et qui comprend une pluralité de lignes de grille (24, 25), une pluralité de lignes de source (26, 27, 28) et une pluralité d'éléments d'image (32, 33), chacun des éléments d'image comprenant un transistor à couches minces (29, 101), le panneau de matrice active comprenant, de plus, un circuit de commande de ligne de grille (21) et un circuit de commande de ligne de source (12) et étant caractérisé en ce qu'au moins l'un du circuit de commande de ligne de grille et du circuit de commande de ligne de source comprend un registre à décalage statique, le registre à décalage statique comprenant un circuit d'inverseur et de porte de transmission, le circuit de porte de transmission recevant un signal d'horloge et sortant un signal d'horloge inversé et comprenant une pluralité de transistors à couches minces complémentaires en silicium polycristallin (47 à 56 ; 58, 59 ; 99, 100) prévus sur le substrat transparent.

FIG.1

FIG.2(a)

FIG.2(b)

FIG.2(c)

FIG.2(d)

FIG.2(e)

FIG.2(f)

99    100

85   83   80   81
84   82   72   78   73   74   75   79   76   77
71

FIG. 3(a)

98

97

96

101

93   91
95   94
87   90   88   89   103   92
102
86

FIG. 3(b)

FIG.4(a)

FIG.4(b)

FIG.4(c)

FIG.4(d)

IDS

10^10

10^8

10^6

10^4

10^2

IDS

$\overline{V}$ DS

$\overline{V}$GS

-10     0     10     20     $\overline{V}$GS

FIG.5

143

144 (L)

142

145     ($\overline{W}$)

FIG.6

151     150

148

147     $x$     tsi     149

146

FIG.7

176   163   164   161

172   165     177   173

179   180   178   166   160

167

168   171

169   170

174   175

162     FIG.8

FIG. 9

FIG. 10(a)

FIG. 10(b)

FIG. 11(a)

FIG .11(b)

FIG.12

FIG.13(a)

FIG.13(b)

280

281

282

284

283

289

285

287

288

291

286

292

290

F I G.14

300

301

302

303

305

304

306

F I G.15(a)

324

323

325

326

327

321

318

317

319

322

320

311

316

312

313

314

315

310

F I G. 15(b)

333  331  332  334  338
339

330  335
337  336  336  337

340

F I G . 16(a)

331  330  338  335

342

332

341

F I G.16(b)

350  351  362  352

356  357  358
359
360

354  355
361
353

F I G.17

FIG.18

FIG.19